# EUROPEAN PATENT APPLICATION

(11) **EP 4 386 614 A1**
(43) Date of publication of application: **19.06.2024**
(21) Application number: 22212765.6
(22) Date of filing: 12.12.2022
(51) Int. Cl.: G06F 30/33

(54) **VERIFICATION OF A LOGIC CIRCUIT**

(71) Applicant: Siemens Electronic Design Automation GmbH, 80634 München (DE)
(72) Inventor: Novikau, Yakau, 81243 München (DE); Chandrasekharan, Arun, 82256 Fürstenfeldbruck (DE); Strasser, Dominik, 82194 Gröbenzell (DE)
(74) Representative: Siemens Patent Attorneys

(57) **Abstract**

A computer-implemented method of verifying a logic circuit (10, 11), calculating a Boolean polynomial representation of the one or more primary outputs (3) of the logic circuit (10, 11) based on a Boolean polynomial expression of one or more outputs (30, 31) of a first section (20, 22) of the logic circuit (10, 11) and according to the one or more arithmetic operations corresponding to logical operations of a second section (21, 23) of the logic circuit (11, 11).

## Description

### TECHNICAL FIELD

The present disclosure relates electronic design automation. The present disclosure also relates to verification of one or more logic circuits and in particular to equivalence checking.

### BACKGROUND

Many industries, such as the automotive industry, mobile phones etc., have incorporated sophisticated electronics in their products and/or services. It is critical to understand that the electronics enabling these features also present countless new opportunities for things to go wrong if they are not adequately verified. These risks have caused industries to adopt stringent safety-related standards for electrical or electronic systems.

Failures happen when an element of a electtonic system does not perform its required function. Such failures are caused by errors, such as a hardware component not behaving as expected. Errors are caused by faults either in the design of the device, or occurring during its operation. Electronic circuit design, and in aprticular electronic desgin automation, comprises the analysis and synthesis of electronic circuits. Examples of failures, e.g., concerning safety in the automotive field, and remedies for detecting and avoiding them are provided in European patent application publication EP3642637A1.

### SUMMARY

The enormous growth in the complexity of integrated circuits is continuing. However, verification resources are limited, which applies to available time prior to fabrication (time-to-market) and also the computational resources in terms of computational power and memory. If the complexities of a verification method are unknown, it becomes impossible to predict the required resources before performing the verification task itself. As a result, it is possible that the resources are exceeded during verification. This poses a big challenge in the design and/or verification process that might influence the schedule for the implementation and fabrication of an electronic circuit. It is thus desired to limit the verification run-time and memory usage to polynomial space, for which scalability can be achieved.

It is thus an object to further reduce the computational resources required to verify one or more logic circuits.

The object is achieved by the subject-matter of the independent claims. Furhter advantageous embodiments are provided in the dependent claims.

### BRIEF DESCRIPTION OF THE DRAWINGS

Figure 1 illustrates a hardware description language model of a logic circuit.
Figure 2 shows a first implementation of a logic circuit, i.e. first logic circuit.
Figure 3 shows a mapping of a truth table of a Boolean operator to an arithmetic operation of a Boolean algebra.
Figure 4 shows a second implementation of a logic circuit, i.e. second logic circuit.
Figure 5 illustrates a software tool for verification of logic circuit.

### DETAILED DESCRIPTION

A logic circuits may make use of interconnected transistors to create logic elements that provide logic operations of Boolean logic, such as AND, NAND, OR, NOR, XOR and combinations thereof. Therein, the transistors may remain in a state until changed by an external input. A logic element generates a binary signal. Thus, logic circuits can provide logic and/or memory, enabling them to perform one or more computational functions. A logic circuit may be part of a mircroprocessor, a ASIC and/or FPGA.

Verification, and in particular formal verification, may be applied to hardware, is the act of proving or disproving the correctness of an intended algorithms underlying system with respect to a certain formal specification or property.

Hence, to design a logic circuit, such as an electrical circuit, electrical engineers need to be able to predict the voltages and currents at all places within the circuit.

More complex digital circuits are typically designed with the aid of computer software. Logic circuits (and sometimes mixed mode circuits) are often described in such hardware description languages as HDL, VHDL or Verilog in a hardware description language model 1, then synthesized using a logic synthesis engine.

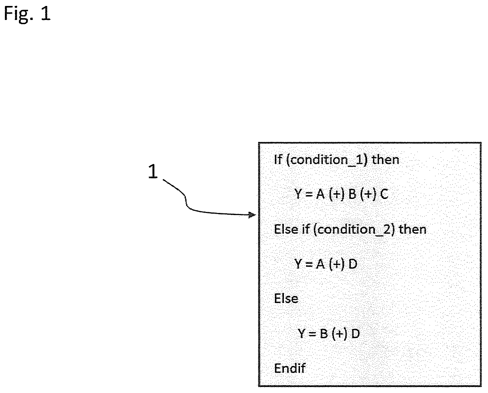

An example of specification of a logic circuit in a hardware description language model 1 is shown in Figure 1. The specification of such systems can be in a hardware description language such as Verilog, VHDL or SystemC.

As illustrated, the primary inputs to the logic circuit are specified as condition_1, condition_2, A, B, C and D. Further, the final primary output of the logic circuit is Y.

The implementation of such a hardware description language model 1 has a wide variety of choices with different pre-processing steps, for example, could make use of a cascade of XOR gates or one huge XOR. XOR tree logic is commonly encountered in areas employing cryptography. The XOR tree logic employs Boolean Exclusive OR gate together with Boolean negation (a Boolean NOT gate, sometimes also called an inverter).

The implementation typically results in a differently balanced XOR trees with respect to the specification, i.e., the number of levels of XOR logic from the inputs to the outputs in the specification and the implementation are different. Formally verifying an XOR tree logic with respect to a specification is a challenging task. It is even more challenging when the XOR trees are differently balanced and/or when other pre-processing logic circuitry is present. State-of-the-art formal verification techniques employing Boolean Satisfiability solvers (SAT solvers) or Binary Decision Diagrams (BDD) run into scalability issues.

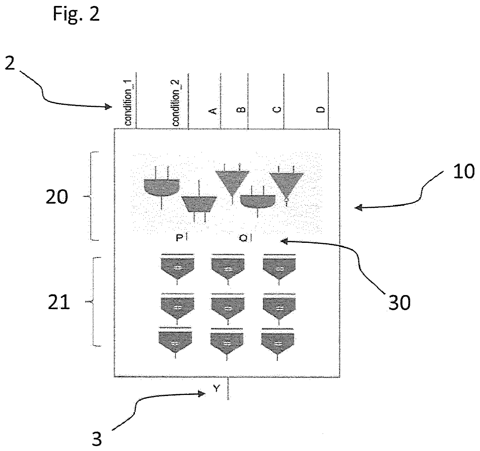

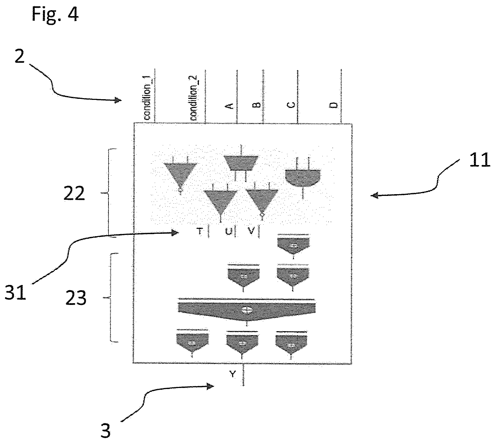

Figures 2 and 4 show XOR logic specification and two different possible implementations. Here, the primary inputs 1 to the logic circuit 10 are condition_1, condition_2, A, B, C and D. Further, the final primary output 3 is Y. Note that these inputs/outputs could be single bit signal or multi-bit words. For example, "A" may be represented with 8 bits in binary logic. The logic circuit 10 may be obtained as a result of the specification of the logic circuit, e.g. of Figure 1.

The first implementation of the logic circuit 10, shown as implementation_1, in Figure 2 employs Boolean logic, e.g., logic element such as gates, for example gates AND/OR/NOT etc., and followed by a 3 level XOR circuitry to derive the final output "Y".

The second logic circuit 11, shown as implementation_2 in Figure 4, uses a different combination of logic gates and then a 4 level XOR circuitry. Both the implementations have different levels of XOR logic and are differently balanced - the first one with 3 levels and the second one with 4 levels.

Such implementations can be split into an XOR core logic part, i.e., a second section 21, and an additional pre-processing or control logic, i.e., a first section 20. The intermediate outputs 30 in implementation-1 after the pre-processing logic 20 is P and Q. Similarly, the intermediate outputs 31 in implementation-2 after the pre-processing logic 22 are T, U and V. Note that, the intermediate outputs do not have any correspondence between the implementations. i.e., as such, the intermediate outputs {P, Q} are not equivalent to {T, U, V}. Further, the pre-processing parts 30, 22 can contain arbitrarily any Boolean logic, including XORs. However, the XOR-part, i.e. said second section 21, 23 strictly contains only XOR and negations.

The task of the (formal) verification is to prove (alternatively disprove) that the whole implementation taken from the primary inputs 2 to primary outputs 3 is functionally equivalent to the specification 1. Stated differently, the task of formal verification boils down to prove (or alternatively disprove) that the primary output 3 generates the same Boolean values under all combinations of Boolean values for primary inputs 2.

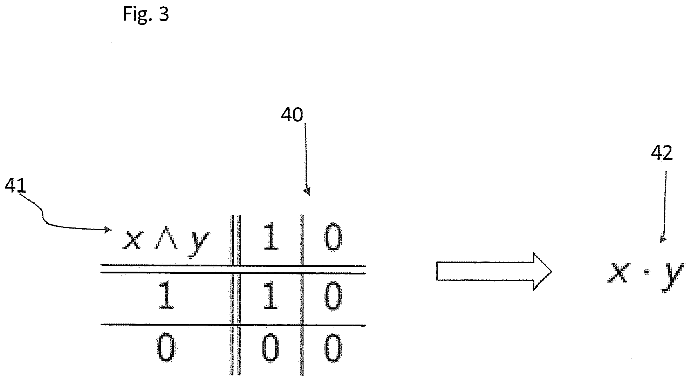

Now turning to Figure 3, which shows a mapping of a truth table 40 of a Boolean operator 41 to an arithmetic operation of a Boolean algebra 42. Boolean polynomials are canonical representation of Boolean functions. However, Boolean polynomials are expensive to construct by standard methods based on using all truth table values as the tables grow exponentially with respect to the number of function variables, and boolean polynomials themselves grow exponentially on the number of polynomial terms. It is thus proposed to use Boolean polynomials for the (formal) verification. In addition, a decomposition of the logic circuit into at least one first section and at leat one second section may be made that limits the resources needed for the construction of the boolean tables, and/or boolean polynomials, and/or the exponential growth of polynomial terms for the verification problem under consideration.

First, an intermediate stage is determined that separates the XOR part, e.g., said second section, from the pre-processing part, e.g., said first section. This may be achieved using structural traversal from the primary output back to the primary inputs. Further, Boolean polynomials 42 may be constructed for the intermediate outputs, i.e. outputs of the first section, in the pre-processing part from the Boolean functions 41 or boolean tables 40, of the respective intermediate outputs. As the functions of intermediate outputs depend on relatively fewer number of input variables, constructing polynomials is more feasible. In the next step, the XOR part, i.e. said second section, is taken, and the Boolean polynomials found in the previous step are substituted in the XOR logic starting from the intermediate outputs to the final outputs. Thus, boolean polynomials of reasonable size can be build using this decomposition that splits XOR-part from the pre-processing part. This, saves resources and processing time. Further, duplicated polynomial terms may be identified and/or eliminated. Finally, a canonical representation of the primary output function "Y" amy be obtained. The Boolean polynomials of different implementations can be compared directly by syntactic matching of the terms.

The one or more steps described herein may be used for checking equivalence between a specification comprising XOR logic and an implementation comprising a differently balanced XOR logic with additional pre-processing logic, wherein both specification and implementation are represented by a Boolean Polynomial. Therein, the Boolean polynomials are constructed for the specification and the differently balanced implementations. The Boolean polynomials may be constructed for the non-XOR logic. The Boolean polynomials constructed may then be substituted to the XOR tree. The canonical representations of the Boolean polynomial(s) generated for the individual implementation may be compared with each other for the formal equivalence checking.

Another exemplary embodimetn is provided in the following: As meantioned, a Boolean variable is a variable v which can take value 0 or 1 (false or true). Then a boolean arithmetic operation such as ⊕ maybe defined which is module 2 sum and corresponds to the Boolean XOR operator. Further ¬ may be defined as a Boolean negation operator. Given Boolean variables a,b,c, the following rules of Boolean algebra can be used: a ⊕ a = 0; b ⊕ 1 = ¬b; c ⊕ 0 = c. Further boolean algebraic rules such as the commutative law ⊕ b = b ⊕ a and/or associative law (a ⊕ (b ⊕ c)) = ((a ⊕ b)⊕ c) may be used. According to commutative and associative laws for XOR operations any permutation of Boolean variables and Boolean constants is allowed thus the brackets can be omitted for brevity, for example, a ⊕ b ⊕ c ⊕ d ⊕ 1 = c ⊕ a ⊕ d ⊕ b ⊕ 1. Using these rules it is possible to eliminate negations in the XOR opertions, such as in the second section of the logic circuit. For example, when a ⊕ ¬b ⊕ ¬c ⊕ ¬d is considered, ¬b = b ⊕ 1, ¬c = c ⊕ 1, ¬d = d ⊕ 1. Thus, the formula above is equal to a ⊕ b ⊕ 1 ⊕ c ⊕ 1 ⊕ d ⊕ 1. Furthermore, using commutative and associative laws the ⊕ 1 operations can be group, for example a ⊕ b ⊕ c ⊕ d ⊕ 1 ⊕ 1 ⊕ 1. Thus for example yields 1 ⊕ 1 ⊕ 1 = 1. Finally, this yields a ⊕ b ⊕ c ⊕ d ⊕ 1. Such transformations can be generalized into the rule of constructing XOR operations for XOR-trees, i.e. for the second section of the logic circiot.

For example, an XOR-tree, i.e. the second second of the logic circuit, may have input variables a,b,c,d. If the XOR-gates contain an odd number of negations, the second section representing the XOR-tree may be expressed as a ⊕ b ⊕ c ⊕ d ⊕ 1, otherwise, it is expressed as a ⊕ b ⊕ c ⊕ d. In other words, the constant 1 in the XOR-tree, or second section, may be used if and only if the total number of negations is odd in the XOR-tree.

These rules are used to construct Boolean polynomials by substitution. A positive elementary conjunction is a conjunction of Boolean variables. For example, a Λ b Λc, that is there are no variable negations. A positive elementary conjunction which does not contain Boolean variables may be represented by the Boolean constant 1. Boolean polynomials are the canonical form of representing Boolean functions. That is, each Boolean function is represented by exactly one Boolean polynomial. For the purpose of synthesizing optimized Boolean circuits, boolean polynomials can be used which contain conjunctions with negations of Boolean variables. Each Boolean function can be represented by a variety of such polynomials and one can try to find a polynomial which is best for a certain purpose.

Now, for the purpose of formal verification Boolean polynomials without negations of Boolean variables which uniquely represent Boolean functions may be used. However, the synthesis method(s) for constructing one or more logic circuits to be verified, can yield boolean polynomials with negated variables.

After substituting Boolean polynomials into the XOR operations, e.g., of the second section, repetitions of conjunctions may be obtained. Such duplicats may be eliminated by using the rules set out above. For example considering the following XOR operations (of the second section) x ⊕ y ⊕ z ⊕ 1 and the boolean polynomials (of the first section) to substitute x = a Λ b Λc ⊕ b Λc ⊕ a Λ b ⊕ 1; y = a Λ b ⊕ b Λc ⊕ b; z = c ⊕ a Λ b ⊕ 1. After substitution a Λ b Λc ⊕ b Λc ⊕ a Λ b ⊕ 1 ⊕ a Λ b ⊕ b Λc ⊕ b ⊕ c ⊕ a Λ b ⊕ 1 ⊕ 1 is obtained. The set of positive elementary conjunctions having even number of duplicates should be removed. For example, set b Λc, b Λc to be removed. The set of positive elementary conjunctions having odd number of duplicates should be replaced with only one conjunction. For example, a Λ b, a Λ b, a Λ b -> a Λ b and 1,1,1 -> 1. Finally, we get Boolean polynomial a Λ b Λc ⊕ a Λ b ⊕ b ⊕ c ⊕ 1 is obtained as a Boolean polynomial representation, e.g. of the primary outputs of the logic circuit.

It should be understood that the substituion of the XOR operations may be done for a logic circuit containing only XOR operations.

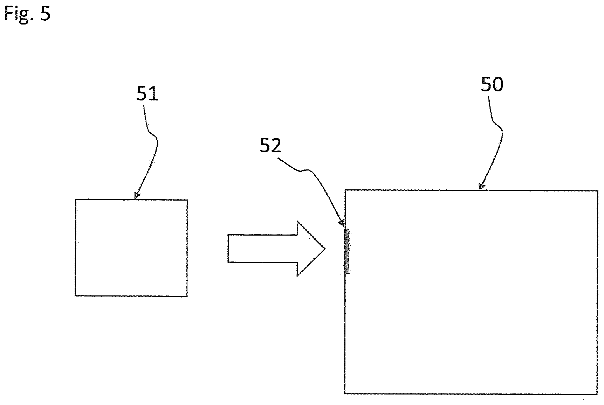

As shown in Figure 5 a software tool 50 may be provided the performs the one or more steps described herein. To that end, the software tool 50, may comprise a solver, that obtaines the Boolean polynomial representation of the one or more primary outputs of the logic circuit as an input 51. Alternatively, the software tool 50 may obtain a specification of the logic circuit, e.g., in a hardware description language, for example as a hardware description language model, as an input 51.

The software tool 50 may comprise further components, e.g., for synthesizing the one or more logic circuits based on the specification, i.e. said hardware description language model. To that, end the software tool 50 comprise an interface 52 for receiving the specification, e.g., said the hardware description language model.

The software tool 50 may then perform the verification. The verification is an attempt to prove, by mathematical methods, that the logic circuit has certain desired properties, and that certain undesired effects (such as deadlock) cannot occur. The result of the verification may be output, by the software tool 50, e.g., in a memory or may be displayed on a display.

Further exemplary steps and embodiments are decribed in the following:
In a first step, a Boolean polynomial representation of the one or more primary outputs of the logic circuit may be calculated.

The logic circuit may comprise one or more primary inputs and one or more primary outputs. The primary input(s) and output(s) limit the logic circuit (according to its design) from the environment and/or other logic circuits, e.g. implementing other primary functions. Hence, the logic circuit may implement a primary function and/or serves to execute a primary function. It are these primary inputs and outputs via which the logic circuitry interacts with the environment.

A boolean polynomial may be interpreted as a logical statement. A boolean polynomial may be understood as an expression involving variables x1,x2,...,xm representing Boolean values, and arithmetic operations.

The calculation of the Boolean polynomial representation may be based on a Boolean polynomial expression of one or more outputs of a first section of the logic circuit and according to the one or more arithmetic operations corresponding to logical operations of a second section of the logic circuit

It should be understood that herein the term boolean polynomial expression is used to identify the boolean polynomial relating to the output of the first section and the term boolean polynomial representation is used to denote the boolean polynomial relating to the primray output of the logic circuit.

Thus, a boolean polynomial expression of the outputs of the first section of the logic circuit may serve as a basis for the calculation.

Boolean polynomials which represent equivalent logical statements may be considered equivalent, e.g. if they have the same truth tables. Furthermore, since, for example, boolean multiplication is equivalent to logical conjunction the latter can be replaced by the first. In general, the truth values 0 and 1 amy be interpreted as integers. Thus boolean operations may be expressed with the ordinary operations of arithmetic (where x + y uses addition and xy uses multiplication). The same applies for the other logical operations which may therefore be replaced by their corresponding arithmetic operations. Thus, the logical operations may be replaced by arithmetic operation. Hence, the arithmetic used may be understood as a boolean arithmetic. The logic operations of the second circuit may then be replaced by (boolean) arithmetic operations. For example, the exclusive OR (XOR) is given as an addition in terms of arithemtic operation of the in the boolean algebra or

Here, an advantage is achieved by identifying the first section for which a boolean polynomial shall be determined. Thereby, computing resources and time may be saved. To that end, the logic circuit is separated into at least two sections.

In a second step, the Boolean polynomial expression for each of one or more outputs of the first section of the logic circuit may be obtained. A truth table of the outputs of the first section may be obtained from which the boolean polynomila expression is determined.

Therein, the first section of the logic circuit may be located between primary inputs of the logic circuit and the second section of the logic circuit. The first section and the second section may be adjacent to each other. For example, the logic circuit can comprise or consist said first and second section.

As the case may be, a user may select said first and/or second section in order to obtain the separation of the logic circuit into two sections.

In a third step, a first and a second section of the logic circuit may be determined. Therein, the second section of the logic circuit comprises only one type of logical operations, preferably only XOR operations. Furthermore, the first section comprises a plurality of types of logical operations, e.g., NAND, NOR and XOR. It may be beneficial to identify one or more sections of the logic circuit comprising only one type of logical operations, such as above mentioned second section that only comprises one type, e.g., XOR operations. This may further decrease time and/or processing resources in general for verifying the logic circuit.

In a fourth step, a graph traversal algorithm of a, preferably directed acyclic, graph representing the logical operations of the logic circuit may be performed. Therein, each vertex in the graph corresponds to a logical operation of the logic circuit, and the graph traversal algorithm determines a subgraph of logical elements, e.g., comprising logical operations of only one type, such as XOR.

Graph traversal (also known as graph search) refers to the process of visiting (checking and/or updating) each vertex in a graph. The graph traversal may be a tree traversal. The graph traversal may comprise a depth first search. The graph traversal may be used to identify the first section and/or the second section of the logic circuit.

Hence, a directed acyclic graph representing the logic circuit may be created, and a graph traversal algorithm such as depth-first-search (DFS) may be performed on that graph. This may result in the first and second section. The graph traversal may check a property of the vertex and/or edges of the graph in order to identify whether this vertex or edge belongs represents a certain logical operation. Thereby, contiguous logical elements may be identified comprising only one type of logical operation.

In a fifth step, the logical elements of the subgraph may be identified as the second section of the logic circuit. The logical elements may be of the same type, for example XOR elements or operations.

In a sixth step, Boolean functions of each of the one or more outputs of the first section may be determined. As explained herein, a truth table for each or for at least part or for all of the outputs of the first section may be determined. It should be understood that instead of a truth table a Boolean function can be determined, for example also based on the truth table. Then, a Boolean polynomial expressions may be determined for each of the Boolean functions of the one or more outputs of the first section.

In a seventh step, the logical operations in the second section may be replaced by the corresponding arithmetic operations. As explained, there is a correspondence between the logical operations and the arithmetic operations. Then, the Boolean polynomial representation of the one or more primary outputs may be calculated. To that end, the Boolean polynomial expression may be modified according to the arithmetic operations. As a result of these modifications the Boolean polynomial representation of the is obtained.

In an eight step, the logic circuit may be verified based on the Boolean polynomial representation of the one or more primary outputs of the logic circuit. The verification of the logic circuit may check the correct behavior of a given logic circuit against its specification. This specification can be given in the form of another circuit at some higher level of abstraction or as a description of properties that the circuit has to obey. For example, as described herein, an equivalence checking may comprise the comparison of two Boolean functions. For the verification it may be established that the input and output variables for the two logic circuit descriptions correspond to each other. Once the correspondence is established, it may be determined if the two circuit abstractions have the same functional behavior for all possible input values.

In a nineth step, the steps as described herein may be performed for a first logic circuit and a second logic circuit. That is to say, each logic circuit is subject to said verification or the verification may comprise a comparison of the two circuits based on their respective Boolean polynomial representation. Furthermore, each logical circuit may be subject to the separation into two sections as described herein.

Then, the Boolean polynomial representation of the one or more primary outputs of the first logic circuit may be compared to the Boolean polynomial representation of the one or more primary outputs of the second logic circuit in order to check the equivalency of the first and the second logic circuit.

In a tenth step, the first and the second logic circuit each may comprise a second section with a different number of logic operations, preferably a different number of XOR operations.

In an eleventh step, the first and the second logic circuit each may comprise a first section with one or more outputs having a different Boolean function and thus different Boolean polynomial representations. Furthermore, the first and second circuit may comprise first sections having a different number of outputs.

In a twelfth step, the first and the second logic circuit correspond to the same hardware description language model. The first and second logic circuit may be synthesized based on the hardware description language model. For example, a synthesis tool may perform logic synthesis and as a result the two logic circuit may be obtained. The logic synthesis is a process by which an abstract specification of desired circuit behavior, typically at in a hardware description language, e.g., at the register transfer level (RTL), is turned into a design implementation in terms of logic elements, by way of which the first and/or second circuit may be obtained.

For example, the synthesis tool may be part of said software tool described herein. The synthesis tool may for example perform different optimization procedures based on the hardware description of the logic circuit and as a result different logic circuits, such as said first and/or second logic circuit, may be obtained. This optimization may be understood as a process of finding an equivalent representation of the logic circuit specified in the hardware description language given one or more constraints. This optimization process may be a part of the synthesis described in order to determine an optimal design, e.g., with respect to the smallest number of logical elements, of the logic circuit, which is e.g., part of an integrated circuit.

Finally, a software tool may be provided which comprises the functionality described herein. That is, the software tool may be configured and/or operative to perform the method steps described herein, e.g., upon loading the hardware description of the logic circuit. The software tool may be stored on a non-transitory storage medium. Furthermore, an apparatus comprising a processor and a memory for running the software tool on said apparatus may be provided.

## Claims

1. A computer-implemented method of verifying a logic circuit (10, 11),
calculating a Boolean polynomial representation of the one or more primary outputs (3) of the logic circuit (10, 11) based on a Boolean polynomial expression of one or more outputs (30, 31) of a first section (20, 22) of the logic circuit (10, 11) and according to the one or more arithmetic operations corresponding to logical operations of a second section (21, 23) of the logic circuit (11, 11).

2. The method according to the preceding claim, further comprising:
obtaining the Boolean polynomial expression for each of one or more outputs (30, 31) of the first section (20, 22) of the logic circuit (10, 11), wherein the first section (20, 22) of the logic circuit is located between primary inputs (2) of the logic circuit (10, 11) and the second section (21, 23) of the logic circuit (10, 11), wherein the first section (20, 22) and the second section (21, 23) are adjacent to each other.

3. The method according to any one of the preceding claims, further comprising:
determining a first and a second section (20, 21 ; 22, 23) of the logic circuit (10, 11), wherein the second section (21, 23) of the logic circuit (10, 11) comprises only one type of logical operations, preferably only XOR operations, and wherein the first section (20 ,22) comprises a plurality of types of logical operations, e.g., NAND, NOR and XOR.

4. The method according to any one of the preceding claims, further comprising:
performing a graph traversal algorithm of a, preferably directed acyclic, graph representing the logical operations of the logic circuit (10, 11), wherein each vertex in the graph corresponds to a logical operation of the logic circuit, and the graph traversal algorithm determines a subgraph of logical elements, e.g., comprising logical operations of only one type, such as XOR.

5. The method according to the preceding claim, further comprising:
identifying the logical elements of the subgraph as the second section (21, 23) of the logic circuit (10, 11).

6. The method according to any one of the preceding claims, further comprising:
determining Boolean functions (41) of each of the one or more outputs (30, 31) of the first section (20, 22), and
determining Boolean polynomial expressions for each of the Boolean functions (41) of the one or more outputs (30, 31) of the first section (20, 22).

7. The method according any one of the preceding claims, further comprising:
replacing the logical operations in the second section (21, 23) by the corresponding arithmetic operations and calculating the Boolean polynomial representation of the one or more primary outputs (3).

8. The method according to any one of the preceding claims, further comprising:
verifying the logic circuit (10, 11) based on the Boolean polynomial representation of the one or more primary outputs (3) of the logic circuit ()10, 11.

9. The method according any one of the preceding claims, further comprising:
performing the steps of any one of the previous claims for a first logic circuit (10) and a second logic circuit (11), and comparing the Boolean polynomial representation of the one or more primary outputs (3) of the first logic circuit (10) to the Boolean polynomial representation of the one or more primary outputs (3) of the second logic circuit (11) in order to check the equivalency of the first and the second logic circuit (10, 11).

10. The method according to the preceding claim,
wherein the first and the second logic circuit (10, 11) each comprise a second section (21, 23) with a different number of logical operations, preferably a different number of XOR operations.

11. The method according to the preceding claims 9 and/or 10, wherein the first and the second logic circuit (10, 11) each comprise a first section (20, 22) with one or more outputs (30, 31) having a different Boolean function and thus different Boolean polynomial representations.

12. The method according to the preceding claims 9 to 11, wherein the first and the second logic circuit (10, 11) correspond to the same hardware description language model, and preferably is synthesized based on the hardware description language model (1).

13. A software program (50) for formal verification of a logic circuit (10, 11) operative to perform the method steps of any one of the preceding claims.
